(19) Europäisches Patentamt
European Patent Office
Office européen des brevets

(11) Veröffentlichungsnummer: **0 335 219 A2**

# (12) EUROPÄISCHE PATENTANMELDUNG

(21) Anmeldenummer: **89104977.7**

(51) Int. Cl.4: **G03F 7/10**

(22) Anmeldetag: **20.03.89**

(30) Priorität: **29.03.88 DE 3810632**

(43) Veröffentlichungstag der Anmeldung:
**04.10.89 Patentblatt 89/40**

(84) Benannte Vertragsstaaten:
**AT BE CH DE ES FR GB IT LI NL SE**

(71) Anmelder: **HOECHST AKTIENGESELLSCHAFT**
**Postfach 80 03 20**
**D-6230 Frankfurt am Main 80(DE)**

(72) Erfinder: **Dössel, Karl-Friedrich, Dr.**
**Fritz-Kalle-Strasse 8**
**D-6200 Wiesbaden(DE)**
Erfinder: **Dammel, Ralph, Dr.**
**Eibenweg 39**
**D-6500 Mainz-Bretzenheim(DE)**
Erfinder: **Lingnau, Jürgen, Dr.**
**Karolingerstrasse 10**
**D-6500 Mainz-Laubenheim(DE)**
Erfinder: **Schmitt, Axel, Dr.**
**Lärchenweg 5**
**D-6229 Walluf 2(DE)**

## (54) Positiv arbeitendes strahlungsempfindliches Gemisch und daraus hergestelltes Aufzeichnungsmaterial.

(57) Es wird ein positiv arbeitendes strahlungsempfindliches Gemisch beschrieben zur Herstellung von Leiterplatten, aber auch von Offsetdruckplatten, enthaltend eine Verbindung, die unter Einwirkung von aktinischer Strahlung eine Säure bildet, eine Verbindung, die durch Säure spaltbar ist sowie ein Bindemittel, das in Wasser unlöslich ist, in organischen Lösemitteln und Alkali aber löslich oder zumindest quellbar ist.

Das Bindemittel zeichnet sich dadurch aus, daß es eine Glastemperatur von mindestens 110° C aufweist.

Durch die Anwesenheit der beschriebenen Bindemittel in dem beanspruchten strahlungsempfindlichen Gemisch weisen die mit diesem Gemisch hergestellten Aufzeichnungsmaterialien ein hohes Auflösungsvermögen auf. Auch nach längerer Behandlung unter erhöhten Temperaturen behalten die ausentwickelten Resiststrukturen ihre scharfen Kantenprofile unverändert bei.

Die aus dem beschriebenen strahlungsempfindlichen Gemisch hergestellten Offsetdruckplatten zeigen eine erhöhte Druckauflage.

EP 0 335 219 A2

## Positiv arbeitendes strahlungsempfindliches Gemisch und daraus hergestelltes Aufzeichnungsmaterial

Die Erfindung betrifft ein positiv arbeitendes strahlungsempfindliches Gemisch, enthaltend eine Verbindung, die unter Einwirkung von aktinischer Strahlung eine Säure bildet, eine Verbindung, die durch Säure spaltbar ist sowie ein Bindemittel.

Positiv arbeitende strahlungsempfindliche Gemische, bei denen durch Einwirkung von aktinischer Strahlung auf einen Photoinitiator eine Säure gebildet wird und diese dann in einer Sekundärreaktion ein säurespaltbares Material in den bestrahlten Bereichen in einem entsprechenden Entwickler löslich macht, sind seit langem bekannt.

Die zu verwendenden, durch Säure spaltbaren Materialien werden z.B. in den EP-A-0 022 571; 0 006 626; 0 006 627 und 0 202 196; den DE-A-26 10 842; 35 44 165 und 36 01 264; den DE-C-23 06 248 und 27 18 254 sowie den Deutschen Patentanmeldungen P 37 30 783.5 und P 37 30 785.1 genannt.

Diese säurespaltbare Materialien enthaltenden strahlungsempfindlichen Gemische weisen in der Regel in Wasser unlösliche, in organischen Lösemitteln und Alkali lösliche, zumindest aber quellbare Bindemittel auf. Hierunter zählen vor allem Phenolharze vom Novolak-Typ. Genannt werden Phenol-Formaldehydharze, Kresol-Formaldehydharze, deren Mischkondensate und deren Mischungen sowie Phenol- und Kresolkondensate mit Formaldehyd.

Daneben können auch Vinylpolymerisate wie Polyvinylacetale, Polymethacrylate, Polyacrylate, Polyvinylether, Polyvinylpyrrolidone sowie Styrolpolymerisate, jeweils ggf. durch Comonomere modifiziert, selbst oder in Mischung mit anderen, eingesetzt werden.

Die genannten Bindemittel werden auch in lichtempfindlichen Gemischen enthaltend als lichtempfindliche Verbindungen 1,2-Naphthochinon-2-diazid-4- oder -5-sulfonsäure-chloride bzw. -ester, verwendet. In diesen, weniger lichtempfindlichen Systemen, erwies sich der Wärmestand, d.h. die Temperaturbeständigkeit der Bildstruktur als relativ unkritisch.

Dagegen mußten nach Einführung der oben beschriebenen durch Säure spaltbaren Materialien in Kombination mit Verbindungen, die unter Einwirkung von Strahlung die Säure bilden und die eine sehr hohe Auflösung des bildmäßig belichteten Materials gewährleisten, auch die Anforderungen an die übrigen Bestandteile des strahlungsempfindlichen Gemisches in der Weise gestellt werden, daß nicht nur ein hochdifferenziertes Bild zur Erzielung von Mikrostrukturen durch Bestrahlung mit entsprechender aktinischer Strahlung erzeugt wird, sondern auch nach dem Entwickeln und den Folgeprozeßschritten, insbesondere bei erhöhter Temperatur (z.B. Plasmaätzschritte etc.), die Maßhaltigkeit der Resiststruktur gewährleistet wird. Mit den beschriebenen, bisher verwendeten Bindemitteln, insbesondere den Novolak-Harzen, war eine hinreichende Maßhaltigkeit der Resiststruktur zur Aufrechterhaltung der durch das lichtempfindliche System vorgegebene zu erreichende Auflösungsvermögen nicht mehr gegeben, denn die bisher bekannten Bindemittel weisen lediglich einen Schmelzpunkt von 105 bis 120° C auf (Kapillar-Methode nach DIN 53 181). Ihre Strukturtreue geht aber bereits bei Temperaturen von 70° C verloren. Die Glastemperaturen (Tg) dieser Bindemittel liegen im allgemeinen unter 100° C.

Reine m-Kresol-Formaldehydharze zeigen dagegen in Kombination mit durch Säure spaltbaren Silyletherverbindungen, wie sie in der DE-A-35 44 165 beschrieben werden, in Folge einer wahrscheinlichen Nichtverträglichkeit beider Komponenten keine Entwicklerresistenz. Die gesamte Schicht löst sich fladig ab.

Es bestand daher die Aufgabe, ein positiv arbeitendes strahlungsempfindliches Gemisch bereitzustellen, das einerseits hochauflösende Strukturen nach dem Belichten und Entwickeln erzeugt, andererseits diese Strukturen auch bei höheren Temperaturen Formkonstanz aufweisen.

Die Lösung der Aufgabe besteht in der Bereitstellung eines positiv arbeitenden strahlungsempfindlichen Gemisches, enthaltend eine Verbindung, die unter Einwirkung von aktinischer Strahlung eine Säure bildet, eine Verbindung, die durch Säure spaltbar ist, sowie ein Novolak-Bindemittel, das in Wasser unlöslich, in organischen Lösemitteln und Alkali löslich oder zumindest quellbar ist, und dadurch gekennzeichnet, daß das Novolak-Binde mittel eine Glastemperatur von mindestens 110° C aufweist.

Es war völlig überraschend, daß die beanspruchten Bindemittel auch in Mischung mit lichtempfindlichen Systemen, enthaltend eine unter Einwirkung von Strahlung eine Säure bildende Verbindung in Kombination mit einer durch Säure spaltbaren Verbindung, strukturtreue Bildkontraste liefern, denn diese Systeme sind im Vergleich zu herkömmlichen o-Chinondiazidsystemen als eher niedrig schmelzend bekannt.

In dem erfindungsgemäß beanspruchten strahlungsempfindlichen Gemisch werden solche Bindemittel bevorzugt, die eine Glastemperatur von mindestens 115° C, insbesondere von mindestens 120° C aufweisen.

Die genannten Bindemittel weisen einen RMW-Wert (reduziertes mittleres Molekulargewicht) von 10 bis 40, insbesondere von 15 bis 30 auf.

Bevorzugt sind die Bindemittel, die aus einem Gemisch, das mindestens zu 50 Mol-% ein in meta-Position substituiertes Phenol enthält, entstehen, wobei als Substituenten $(C_1-C_3)$Alkyl, insbesondere Methyl, in Frage kommen. Hierunter wiederum sind insbesondere die Bindemittel zu nennen, deren Gemische zur Herstellung

a) mindestens zu 60 Mol-% ein in meta-Position substituiertes Phenol enthalten und bis zu 40 Mol-% ein trioder bireaktives Phenol der allgemeinen Formel I

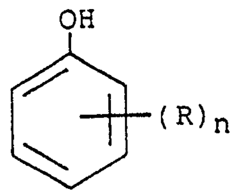

(I)

aufweisen, worin
R $(C_1-C_4)$Alkyl, insbesondere Methyl, Ethyl und/oder t-Butyl und
n eine ganze Zahl von 1 bis 3, insbesondere 2 oder 3
bedeuten, oder

b) mindestens zu 70 Mol-% das in meta-Position substituierte Phenol enthalten und bis zu 30 Mol-% ein monoreaktives Phenol der allgemeinen Formel II

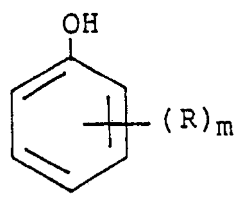

(II)

aufweisen, worin
R $(C_1-C_4)$Alkyl, insbesondere Methyl, Ethyl und/oder t-Butyl und
m eine ganze Zahl von 2 bis 4, insbesondere 3
bedeuten.

Insbesondere bevorzugt werden Bindemittel, deren Gemisch zur Herstellung bis zu 30 Mol-%, besonders bevorzugt bis zu 20 Mol-%, ein tri- oder bireaktives Phenol der allgemeinen Formel I enthalten oder solche, die bis zu 15 Mol-%, besonders bevorzugt bis zu 10 Mol-%, ein monoreaktives Phenol der allgemeinen Formel II enthalten.

Zu den trireaktiven Phenolen zählen solche, die in den Positionen 3, 5 oder 3 und 5 durch R substituiert sind.

Die bireaktiven Phenole weisen sich dadurch aus, daß sie in den Positionen 2 oder 4, den Positionen 2 und 3, 3 und 4, 2 und 5 oder in den Positionen 2,3 und 5 sowie 3,4 und 5 substituiert sind.

Monoreaktive Phenole zeichnen sich dadurch aus, daß sie Substituenten in den Positionen 2 und 4 oder 2 und 6, 2,3 und 4, 2,3 und 6 sowie 2,4 und 5 oder 2,3,4 und 5 sowie 2,3,5 und 6 aufweisen.

Besonders bevorzugt ist, als ein in meta-Position substituiertes Phenol, das m-Kresol. Die Substituenten der Phenole der allgemeinen Formeln I und II sind bevorzugt vom gleichen Typ, besonders bevorzugt ist die Methylgruppe zu nennen.

Ganz besonders bevorzugt sind die reinen m-Kresol-Harze (≧96 Mol-%) (trireaktiv) sowie Bindemittel bestehend aus m-Kresol und weiteren tri- bzw. bireaktiven Verbindungen der allgemeinen Formel I, darunter wiederum diejenigen, die in den Positionen 2 und 3 bzw. 3 und 5 oder 2,3 und 5 substituiert sind, hierunter wieder diejenigen, die in Position 3 und 5 substituiert sind.

Von den Bindemitteln, die aus m-Kresol und monoreaktiven Phenolen der allgemeinen Formel II bestehen, sind diejenigen monoreaktiven Phenole bevorzugt, die in den Positionen 2,3 und 6 substituiert sind.

Neben den Bindemitteln, die insbesondere aus m-Kresolharz bestehen und solchen, die zwei Phenolbestandteile aufweisen, von denen eines insbesondere m-Kresol ist, sind auch Systeme aus mehreren Phenolbestandteilen, enthaltend insbesondere m-Kresol und weitere mono-, bi- oder trireaktive Phenole, geeignet. Insbesondere sind hierunter die Systeme aus drei Phenolbestandteilen zu nennen, wobei neben der Hauptkomponente, dem in m-Position substituierten Phenol, die anderen Komponenten bevorzugt jeweils entweder den mono-, bi- oder den trireaktiven Phenolen zuzuordnen sind. Entstammen diese anderen Komponenten unterschiedlich reaktiven Phenolen, so sind die Mischungsverhältnisse dieser dergestalt, daß immer mehr an trireaktiven als an bi- bzw. an monoreaktiven Phenolen oder mehr an bireaktiven als an monoreaktiven Phenolen in den Gemischen zur Herstellung der Bindemittel vorliegen.

Es war völlig überraschend, daß derartige Gemische zur Herstellung der beschriebenen Bindemittel die erforderlichen Eigenschaften zur Gewährleistung der Maßhaltigkeit der diese Bindemittel enthaltenden erfindungsgemäßen strahlungsempfindlichen Gemische gewährleisten.

Die in den erfindungsgemäßen strahlungsempfindlichen Gemischen enthaltenen Bindemittel entstehen durch Kondensa tion der beschriebenen Phenolkomponenten mit Carbonyl-Komponenten. Zu diesen zählen aliphatische Aldehyde, insbesondere Formaldehyd, Acetaldehyd oder Propylaldehyd, sowie deren Derivate, wie z.B. die des Formaldehyds, der Paraformaldehyd und das Trioxan, ebenso Acrolein, Benzaldehyd, 4-Hydroxy-benzaldehyd, Aceton, Methylethylketon, Diethylketon, Methyl-isobutyl-keton, Acetophenon, Benzylmethylketon, u.a.

Von diesen sind besonders bevorzugt Formaldehyd und Acetaldehyd, die sowohl alleine als auch in Mischung miteinander eingesetzt werden können.

Das Molverhältnis der Carbonylkomponente(n) zu der eingesetzten Phenolkomponente(n) beträgt 0,80 bis 0,95 zu 1 (Einstand). Der jeweils optimale Gehalt richtet sich nach der Reaktivität der verwendeten Phenolkomponenten. Werden sehr reaktive Phenolkomponenten benutzt, kann der Gehalt der Carbonylkomponente auch unter 0,85 Mol : 1 Mol Phenolkomponente betragen. Vorzugsweise wird aber ein Verhältnis von 0,9 Mol : 1 Mol (Carbonylkomponente : Phenolkomponente) eingesetzt.

Zum Kondensieren der genannten Bestandteile muß das Gemisch zur Herstellung der Bindemittel eine Säure enthalten. Hierunter zählen sowohl organische Säuren, wie z.B. Maleinsäureanhydrid, Oxalsäure, Ameisensäure, Essigsäure, Trifluoressigsäure, Methansulfonsäure, Toluolsulfonsäure als auch anorganische Säuren, wie z.B. Schwefelsäure und Phosphorsäure. Bevorzugt ist die Oxalsäure.

Ihr Gehalt liegt bei etwa 0,01 bis 6 Gew.-%, insbesondere bei 1 bis 4 Gew.-%, jeweils bezogen auf die Phenolkomponente in der Mischung. Sofern die wesentlich stärkeren anorganischen Säuren verwendet werden, können niedrigere Säurekonzentrationen als angegeben gewählt werden.

Vorteilhaft für die Kondensation ist die Gegenwart eines Lösungsmittels oder Lösemittelgemisches, wobei der Siedepunkt des Lösemittels zwischen 120 und 200° C, insbesondere zwischen 140 und 190° C liegt. Genannt werden z.B. Glykolether wie Methylglykol, Ethylglykol, Butylglykol, Methoxybutanol, Dimethylformamid, Diethylenglykoldimethylether, Ethylglykolacetat, Methylpropylenglykolacetat. Vorzugsweise werden hydroxylgruppenfreie Lösemittel verwendet, und in Mengen von 0,2 bis 1,0 Gewichtsteilen pro Gewichtsteil Phenolgemisch eingesetzt.

Die Menge des Bindemittels beträgt im allgemeinen 1 bis 90, insbesondere 5 bis 90 Gew.-%, vorzugsweise 50 bis 90 Gew.-%, bezogen auf das Gesamtgewicht des strahlungsempfindlichen Gemisches.

Für das erfindungsgemäße strahlungsempfindliche Gemisch kommen als Komponenten, die beim Bestrahlen vorzugsweise eine starke Säure bilden bzw. abspalten, eine große Anzahl von Verbindungen und Mischungen derselben in Frage. Zu nennen sind Diazonium-, Phosphonium-, Sulfonium- und Iodonium-Salze, Halogenverbindungen, o-Chinondiazidsulfochloride und -ester sowie Organometall-Organohalogen-Kombinationen.

Die genannten Diazonium-, Phosphonium-, Sulfonium- und Iodonium-Verbindungen werden in der Regel eingesetzt in Form ihrer in organischen Lösungsmitteln löslichen Salze, meist als Abscheidungsprodukt mit komplexen Säuren wie Borfluorwasserstoffsäure, Hexafluorphosphor-, Hexafluorantimon- und -arsensäure. U.a. werden diese Verbindungen auch in der DE-A-36 01 264 genannt.

Unter die Halogenverbindungen zählen insbesondere Triazinderivate, die aus den US-A-3 515 552, 3 536 489 und 3 779 778 sowie den DE-C-27 18 259, 33 37 024, 33 33 450, 23 06 248, 22 43 621 und 12 98 414 bekannt sind. Diese können aber auch in Kombination mit anderen Photoinitiatoren wie Oxazolen, Oxadiazolen oder Thiazolen, aber auch untereinander in Mischungen eingesetzt werden.

Es sind aber auch Oxazole, Oxadiazole, Thiazole oder 2-Pyrone bekannt, die Trichlor- oder Tribrommethylgruppen enthalten (DE-A-30 21 599, 30 21 590, 28 51 472, 29 49 396 sowie EP-A-0 135 348 und 0 135 863).

Ebenso zählen unter diesen Oberbegriff insbesondere auch aromatische Verbindungen, die kernständiges Halogen, vorzugsweise Brom aufweisen. Solche Verbindungen sind aus der DE-A-26 10 842 bekannt

oder werden in der deutschen Patentanmeldung P 37 30 784.3 beschrieben.

Als Vertreter einer Kombination mit einem Thiazol sei eine mit 2-Benzoylmethylen-naphtho [1,2-α]-thiazol genannt (DE-A-28 51 641 und DE-A-29 34 758). Ein Gemisch einer Trihalogenmethylverbindung mit N-Phenylacridon ist aus der DE-A-26 10 842 bekannt.

Ebenso stehen α-Halogencarbonsäureamide (DE-A-27 18 200) oder Tribrommethyl-phenylsulfone (DE-A-35 03 113), die z.B. durch Benzophenon, Benzil oder Michlers Keton sensibilisiert werden können, zur Verfügung.

In der Regel können aber alle beschriebenen licht- bzw. strahlungsempfindlichen Verbindungen durch Photosensibilisatoren in ihrer Effektivität unterstützt werden. Zu nennen sind z.B. Anthracen, Phenanthren, Pyren, 1,2-Benzanthren, Thiazine, Pyrazoline, Benzofurane, Benzophenone, Fluorenone, Anthrachinone sowie Cumarinderivate. Ihr Gehalt liegt bei 0,01 bis 5 Gew.-%, bezogen auf das Gewicht des strahlungsempfindlichen Gemisches.

Besonders bevorzugt sind vor allem Triazinderivate sowie aromatische Verbindungen mit kernständigem Halogen, insbesondere Brom, aus der DE-A-26 10 842 sowie der deutschen Patentanmeldung P 37 30 784.3.

Vorzugsweise werden diese Verbindungen erst bei energiereicher, d.h. kürzerwelliger Strahlung gespalten. Hierunter zählt vor allem neben UV-Strahlung Elektronen- oder Röntgenstrahlung.

Neben monomeren strahlungsempfindlichen Verbindungen können auch Polymere dieser Art eingesetzt werden. Bei Verwendung von monomeren Startern liegt deren Gehalt im Bereich von 0,01 bis 30 Gew.-%, insbesondere von 0,4 bis 20 Gew.-%, bezogen auf das Gewicht der strahlungsempfindlichen Mischung.

Werden polymere Starter verwendet, so kann ggf. z.T. auf das erfindungsgemäß enthaltende Bindemittel verzichtet werden. Dies hat zur Folge, daß dessen Gehalt in Abhängigkeit von seinem Anteil am Gehalt des Polymeren in dieser Mischung auch über den beschriebenen Bereich bei monomeren Startern hinausgehen kann. Insbesondere werden Gehalte von größer als 50 Gew.-% und bis zu 99 Gew.-%, abzüglich des Gehaltes der Verbindung, die durch Säure spaltbar ist, in Anspruch genommen.

Als durch Säure spaltbares Material in dem erfindungsgemäßen strahlungsempfindlichen Gemisch haben sich vor allem folgende Verbindungsklassen bewährt:

a) solche mit mindestens einer Orthocarbonsäureester-und bzw. oder Carbonsäureamidacetalgruppierung, wobei die Verbindungen auch polymeren Charakter haben und die genannten Gruppierungen als verknüpfende Elemente in der Hauptkette oder als seitenständige Substituenten auftreten können,

b) Oligomer- oder Polymerverbindungen mit wiederkehrenden Acetal- und/oder Ketalgruppierungen in der Hauptkette,

c) Verbindungen mit mindestens einer Enolether- oder N-Acyliminocarbonatgruppierung,

d) cyclische Acetale oder Ketale von β-Ketoestern oder -amiden,

e) Verbindungen mit Silylenolethergruppierungen und

f) Monoacetale bzw. Monoketale, deren Aldehyd- bzw. Ketonkomponente eine Löslichkeit im Entwickler zwischen 0,1 und 100 g/l aufweisen,

g) Ether auf Basis tertiärer Alkohole,

h) Carbonsäureester und Carbonate tertiärer, allylischer oder benzylischer Alkohole.

Durch Säure spaltbare Verbindungen des Typs a) als Komponenten strahlungsempfindlicher Gemische sind in der EP-A-0 022 571 und der DE-A-26 10 842 ausführlich beschrieben; Gemische, die Verbindungen des Typs b) enthalten, sind in der DE-C-23 06 248 und der DE-C-27 18 254 dargestellt; Verbindungen des Typs c) werden in den EP-A-0 006 626 und 0 006 627 beschrieben; Verbindungen des Typs d) werden in der EP-A 0 202 196 vorgestellt; Verbindungen des Typs e) findet man in der deutschen Patentanmeldung P 37 30 783.5, während Verbindungen vom Typ f) in den deutschen Patentanmeldungen P 37 30 785.1 und P 37 30 787.8 behandelt werden. Verbindungen vom Typ g) werden z. B. in der US-A-4 603 101 beschrieben, Verbindungen vom Typ h) z. B. in der US-A-4 491 628 und von J. M. Fréchet et al., J. Imaging Sci. 30, 59-64 (1986).

Es können auch Mischungen der genannten säurespaltbaren Materialien eingesetzt werden. Bevorzugt ist allerdings ein säurespaltbares Material, welches einem der oben genannten Typen zuzuordnen ist. Besonders bevorzugt sind von den Materialien diejenigen, die mindestens eine durch Säure spaltbare C-O-C-Bindung aufweisen, sowie insbesondere solche, die den Typen a), b), f) und h) angehören. Unter Typ b) sind insbesondere die polymeren Acetale hervorzuheben; von den säurespaltbaren Materialien des Typs f) insbesondere diejenigen, deren Aldehyd- bzw. Ketonkomponente einen Siedepunkt von größer als 150° C, vorzugsweise größer als 200° C, aufweist.

Der Gehalt an säurespaltbarem Material in dem erfindungsgemäßen strahlungsempfindlichen Gemisch sollte bei 1 bis 50 Gew.-%, vorzugsweise bei 5 bis 25 Gew.-%, jeweils bezogen auf das Gesamtgewicht der

Schicht, liegen.

Ferner können den erfindungsgemäßen strahlungsempfindlichen Gemischen ggf. Farbstoffe, Pigmente, Weichmacher, Netzmittel und Verlaufmittel, aber auch Polyglykole, Celluloseether, z.B. Ethylcellulose, zur Verbesserung spezieller Erfordernisse wie Flexibilität, Haftung und Glanz zugesetzt werden.

Vorzugsweise wird das erfindungsgemäße strahlungsempfindliche Gemisch in Lösungsmitteln wie Ethylenglykol, Glykolethern wie Glykolmonomethylether, Glykoldimethylether, Glykolmonoethylether oder Propylenglykolmonoalkylether, insbesondere Propylenglykolmethylether; aliphatischen Estern wie Ethylacetat, Hydroxyethylacetat, Alkoxyethylacetat, δ-Butylacetat, Propylenglykolmonoalkyletheracetat, insbesondere Propylenglykolmethyletheracetat oder Amylacetat; Ethern wie Dioxan, Ketonen wie Methylethylketon, Methyliso-butylketon, Cyclopentanon und Cyclohexanon; Dimethylformamid, Dimethylacetamid, Hexamethylphosphorsäureamid, N-Methyl-pyrrolidon, Butyrolacton, Tetrahydrofuran, und in Mischungen derselben gelöst. Besonders bevorzugt werden Glykolether, aliphatische Ester sowie Ketone.

Die mit den übrigen Bestandteilen des strahlungsempfindlichen Gemisches entstehenden Lösungen haben in der Regel einen Feststoffgehalt von 5 bis 60 Gew.-%, vorzugsweise bis 50 Gew.-%.

Erfindungsgemäß wird ferner ein strahlungsempfindliches Aufzeichnungsmaterial beansprucht, im wesentlichen bestehend aus einem Substrat und dem darauf aufgetragenen strahlungsempfindlichen Gemisch.

Als Substrate kommen alle Materialien in Frage, aus denen Kondensatoren, Halbleiter, mehrlagige gedruckte Schaltungen oder integrierte Schaltkreise bestehen bzw. hergestellt werden können. Insbesondere sind Oberflächen aus reinem Silicium und thermisch oxidiertem und/oder mit Aluminium beschichtetem Siliciummaterial zu nennen, die gegebenfalls auch dotiert sein können, einschließlich aller anderen in der Halbleitertechnologie üblichen Substrate wie beispielsweise Siliciumnitrid, Galliumarsenid, Indiumphosphid. Weiterhin kommen in Frage die aus der Flüssigkristalldisplay-Herstellung bekannten Substrate wie Glas, Indium-Zinnoxid; ferner Metallplatten und -folien, beispielsweise aus Aluminium, Kupfer, Zink; Bimetall-und Trimetallfolien, aber auch elektrisch nicht leitende Folien, die mit Metallen bedampft sind, gegebenenfalls mit Aluminium beschichtete $SiO_2$-Materialien und Papier. Diese Substrate können einer Temperatur-Vorbehandlung unterzogen werden, oberflächlich angerauht, angeätzt oder zur Erzielung erwünschter Eigenschaften, wie z. B. Erhöhung der Hydrophilie, mit Chemikalien behandelt sein.

In einer besonderen Ausführungsform kann das strahlungsempfindliche Gemisch zur besseren Haftung einen Haftvermittler enthalten oder dieser kann auch zwischen dem Resist und dem Substrat als Zwischenschicht vorhanden sein. Bei Silicium- bzw. Siliciumdioxid-Substraten kommen hierfür Haftvermittler vom AminosilanTyp, wie z.B. 3-Aminopropyl-triethoxysilan oder Hexamethyl-disilazan in Frage.

Beispiele für Träger, die zur Herstellung von photomechanischen Aufzeichnungsmaterialien wie Druckformen für den Hochdruck, den Flachdruck, den Siebdruck, den Tiefdruck sowie von Reliefkopien Verwendung finden können, sind Aluminiumplatten, ggf. anodisch oxidiert, gekörnte und/oder silikatisierte Aluminiumplatten, Zinkplatten, Stahlplatten, die ggf. mit Chrom bearbeitet wurden, sowie Kunststoffolien oder Papier.

Das erfindungsgemäße Aufzeichnungsmaterial wird bildmäßig bestrahlt. Quellen aktinischer Strahlung sind: Metallhalogenidlampen, Kohlebogenlampen, Xenonlampen und Quecksilberdampflampen. Bevorzugt wird eine Bestrahlung mit energiereicher Strahlung wie Laser-, Elektronen- oder Röntgenstrahlung. Als Laser werden insbesondere Excimer-Laser, Argon-Laser, Krypton-Laser sowie Helium/Cadmium-Laser genannt.

Die Schichtstärke variiert in Abhängigkeit von ihrem Einsatzgebiet. Sie beträgt zwischen 0,1 und 100 µm, insbesondere zwischen 0,3 und 10 µm.

Gegenstand der Erfindung ist ferner ein Verfahren zur Herstellung eines strahlungsempfindlichen Aufzeichnungsmaterials. Das Auftragen des strahlungsempfindlichen Gemisches auf das Substrat kann durch Aufsprühen, Fließbeschichten, Walzen, Schleuderbeschichten und Tauchbeschichten erfolgen. Danach wird das Lösungsmittel durch Verdampfen entfernt, so daß auf der Oberfläche des Substrates die strahlungsempfindliche Schicht zurückbleibt. Die Entfernung des Lösemittels kann gegebenfalls durch Erhitzen der Schicht auf Temperaturen von bis zu 140° C gefördert werden. Das Gemisch kann aber auch zunächst auf obengenannte Weise auf einen Zwischenträger aufgetragen werden, von dem aus es unter Druck und erhöhter Temperatur auf das endgültige Trägermaterial übertragen wird.

Anschließend wird die Schicht bildmäßig bestrahlt. Üblicherweise wird aktinische Strahlung verwendet, besonders bevorzugt sind UV-, Röntgen- oder Elektronenstrahlung. Zur Bestrahlung werden UV-Lampen verwendet, die Strahlung einer Wellenlänge von 200 bis 500 nm mit einer Intensität von 0,5 bis 60 $mW/cm^2$ aussenden. In der strahlungsempfindlichen Schicht wird anschließend durch Entwicklung ein Bildmuster freigelegt, indem die Schicht mit einer Entwicklungslösung behandelt wird, die die bestrahlten Bereiche des Materials löst bzw. entfernt.

Als Entwickler werden Lösungen von alkalischen Reagenzien wie z.B. Silikaten, Metasilikaten, Hydroxiden, Hydrogen- bzw. Dihydrogenphosphaten, Carbonaten bzw. Hydrogencarbonaten, insbesondere von Alkali- oder Ammoniumionen, aber auch Ammoniak und dergleichen verwendet. Der Gehalt dieser Substanzen in der Entwicklerlösung beträgt im allgemeinen 0,1 bis 15 Gew.-%, vorzugsweise 0,5 bis 5 Gew.-%, bezogen auf das Gewicht der Entwicklerlösung.

Die entwickelten Resiststrukturen werden ggf. nachgehärtet. Dies geschieht im allgemeinen dadurch, daß man die Resiststruktur auf einer hot-plate bis zu einer Temperatur unter der Fließtemperatur erhitzt und anschließend mit UV-Licht einer Xenon-Quecksilber-Dampflampe (Bereich von 200 bis 250 nm) ganzflächig belichtet. Durch diese Nachhärtung werden die Resiststrukturen vernetzt, so daß die Strukturen eine Fließbeständigkeit im allgemeinen bis zu Temperaturen von über 200° C aufweisen. Die Nachhärtung kann auch ohne Temperaturerhöhung unter Einstrahlung von UV-Licht erfolgen. Dies gilt insbesondere dann, wenn energiereiches Licht verwendet wird, z.B. Elektronenstrahlung.

Die Herstellung der in den erfindungsgemäßen Gemischen enthaltenen Bindemittel erfolgt nach folgender allgemeiner Vorschrift:

3 Mol Kresolgemisch entsprechend den in der Beschreibung angegebenen Mischungsverhältnissen werden in einem Vierhalskolben mit Rückflußkühler und Rührer mit 180 g Diethylenglykoldimethylether gemischt, mit 6,6 g Oxalsäuredihydrat versetzt und auf etwa 100° C erwärmt. Zu diesem Gemisch tropft man entsprechend Tabelle I 37 %ige Formalinlösung (oder eine andere Carbonylverbindung) und hält das Reaktionsgemisch bis zum Verbrauch des Formaldehyds bei schwachem Rückfluß. Anschließend werden Wasser, Lösemittel und nicht umgesetzte Ausgangskomponenten zunächst unter Normaldruck bis 200° C, dann im Wasserstrahlvakuum bis 220° C abdestilliert. Das heiße Novolakharz wird in eine Kühlpfanne entleert und erkalten gelassen.

Die Glastemperatur (Tg in °C) des in dieser Weise gewonnenen Novolakharzes wird mit einem Differentialkalorimeter (DSC 1090 der Fa. Dupont) bei einer Heizrate von 20 K/min bestimmt. Sie ergibt sich aus der Temperatur der halben Stufenhöhe. Die Ergebnisse sind in Tabelle I aufgelistet.

Der Kondensationsgrad des Novolakharzes wird durch den RMW-Wert charakterisiert, der sich aus der relativen Viskosität einer 7 %igen Harzlösung in Cyclohexanon nach folgender Gleichung errechnet:

$$RMW = \left[ \frac{1}{C_1} \times \log \frac{t_1}{t_{1m}} \right]^2$$

Hierin bedeuten:

$t_1$ Durchlaufzeit der Harzlösung durch das Ubbelohde-Viskosimeter,

$t_{1m}$ Durchlaufzeit des Lösemittels (Cyclohexanon) durch das Ubbelohde-Viskosimeter,

$C_1$ Konzentration des Harzes im Lösemittel (Cyclohexanon) in g/100 ml Lösung.

Herstellungsbeispiele:

Nach dem allgemeinen Herstellungsbeispiel werden folgende, in Tabelle I zusammengefaßte Novolak-Bindemittel hergestellt, die anhand ihrer Glastemperatur und ihres RMW-Wertes charakterisiert sind. Sie sollen die Erfindung erläutern, nicht jedoch auf diese beschränkend wirken. Als Vergleichsbeispiel (HV) wurde ein Kresol-Formaldehyd-Novolak mit einem Erweichungsbereich von 105 - 120° C gemäß dem zitierten Stand der Technik aufgenommen (Tg = 94° C).

Tabelle I

| Molverhältnisse (Einstand) | | | | | |
|---|---|---|---|---|---|
| | m-Kresol : | Formel I oder II : | Formaldehyd | Tg [°C] | RMW-Wert |
| H1 | 1,0 | - | 0,9 | 124 | 24,2 |
| H2 | 0,8 | 3,5-Dimethylphenol 0,2 | 0,9 | 132 | 29,4 |
| H3 | 0,9 | 2,3,6-Trimethylphenol 0,1 | 0,9 | 122 | 19,2 |
| H4 | 0,8 | 3,5-Dimethylphenol 0,2 | 0,84 | 124 | 14,9 |
| HV | Kresol-Formaldehyd-Novolak mit Erweichungsbereich 105 - 120° C | | | 94 | 17 |

Die folgenden Anwendungsbeispiele sollen die Erfindung erläutern; nicht jedoch auf diese beschränkend wirken. In den Beispielen stehen Gewichtsteile (Gt) zu Volumenteilen (Vt) im Verhältnis g:$cm^3$, Prozentangaben und Mengenverhältnisse sind, wenn nichts anderes angegeben ist, in Gewichtsteilen zu verstehen.

Beispiel 1

Es wird eine Beschichtungslösung hergestellt, enthaltend
8,2 Gt des Phenolharzes aus Herstellungsbeispiel 1,
1,8 Gt Benzaldehyd-diphenoxyethylacetal gemäß Beispiel 1 der deutschen Patentanmeldung P 37 30 787.8,
0,15 Gt 2(2-Ethoxynaphth-1-yl)-4,6-bis-trichlormethyl-s-triazin in
25 Gt Propylenglykolmethyletheracetat.

Die Beschichtungslösung wird in an sich bekannter Weise auf einen aus Aluminium bestehenden 0,3 mm dicken Druckplattenträger aufgetragen. Der Aluminiumträger war vorher elektrochemisch aufgerauht, anodisiert und mit Polyvinylphosphonsäure hydrophiliert worden. Nach dem Trocknen der Schicht bei 90° C wird eine Schichtdicke von 1,5 µm erhalten.

Die in dieser Weise hergestellte Offsetdruckplatte wird mit einer Kopiervorlage, die einen Halbtonkeil, Mikrolinien von einer Stärke zwischen 4 und 75 µm und Rasterpunkte von 0,5 bis 5 % Flächendeckung enthält, bedeckt. Anschließend wird mit Strahlung einer Quecksilberhochdrucklampe (5 kW) 20 s in einem Abstand von 110 cm bestrahlt.

Die Entwicklung erfolgt mit 0,3 n KOH-Lösung. Man erhält eine positive Druckform mit hoher Auflösung. Die mit die ser Druckform erreichte Druckauflage fehlerfreier Druckexemplare beträgt 30.000.

Beispiel 2 (Vergleichsbeispiel)

Es wird eine Beschichtungslösung hergestellt, die der aus Beispiel 1 entspricht, mit der Ausnahme, daß anstelle des erfindungsgemäß eingesetzten Phenolharzes, 8,2 Gt des Novolaks aus dem Vergleichsbeispiel HV verwendet wird.

Nach Beschichtung, Trocknen, Bestrahlung und Entwicklung analog zu Beispiel 1 wird eine Druckform erhalten, die maximal 10.000 fehlerfreie Drucke liefert.

Beispiel 3

Es wird eine Beschichtungslösung hergestellt, enthaltend
8,2 Gt des Phenolharzes aus Herstellungsbeispiel 1,
1,8 Gt Benzaldehyd-diphenoxyethylacetal gemäß Beispiel 1 der deutschen Patentanmeldung P 37 30 787.8,
0,15 Gt Hexafluortetrabrom-Bisphenol A gemäß Beispiel 1 der deutschen Patentanmeldung P 37 30 784.3 in
25 Gt Propylenglykolmethyletheracetat.

Die Lösung wird auf einen mit einem Haftvermittler (Hexamethyl-disilazan) behandelten Siliciumwafer bei 3.000 U/min aufgeschleudert. Nach der Trocknung bei 85° C für 30 min in einem Umluftofen wird eine

Schichtdicke von 1 µm erhalten.

Bildmäßig bestrahlt wird mit Synchrotron-Strahlung (BESSY, Berlin, Luftspalt 2 mm) einer Dosis von 35 mJ/cm² durch eine Gold-auf-Silicium-Maske. Den experimentellen Aufbau dieser Bestrahlungsvariante findet man bei A. Heuberger, "X-Ray Lithography", Microelectronic Engineering 3, 535-556 (1985). Entwickelt wird 60 s lang mit einer 0,4 n KOH-Lösung. Alle Details konnten fehlerfrei auf das Bild übertragen werden, das sich durch hohe Kantenstabilität und unverändert hohe Restschichtdicke der nicht bestrahlten Bildbereiche auszeichnet.

Erwärmt man ein derart erhaltenes Resistmuster auf 100° C, so wird auch nach 30 min keine Veränderung der Kantenprofile beobachtet.

Beispiel 4

Es wird eine Beschichtungslösung analog zu Beispiel 3 hergestellt, mit dem Unterschied, daß anstelle des Phenolharzes aus Herstellungsbeispiel 1, 8,2 Gt Phenolharz aus Herstellungsbeispiel 2 enthalten ist.

Nach einer völlig mit der in Beispiel 3 identischen Vorgehensweise wird ein Resistmuster erhalten, das auch nach 30 min Erwärmung auf 100° C keine Veränderung der Kantenprofile erfährt.

Beispiel 5

Es wird eine Beschichtungslösung analog zu Beispiel 3 hergestellt, mit dem Unterschied, daß anstelle des Phenolharzes aus Herstellungsbeispiel 1, 8,2 Gt Phenolharz aus Herstellungsbeispiel 3 enthalten ist.

Nach völlig mit der in Beispiel 3 identischen Vorgehensweise wird ein Resistmuster erhalten, das auch nach 30 min Erwärmen auf 100° C keine Veränderung der Kantenprofile erfährt.

Beispiel 6 (Vergleichsbeispiel)

Es wird eine Beschichtungslösung analog zu Beispiel 3 hergestellt, mit dem Unterschied, daß anstelle des Phenolharzes aus Herstellungsbeispiel 1, 8,2 Gt des Novolaks aus dem Vergleichsherstellungsbeispiel HV verwendet wird.

Nach völlig mit der in Beispiel 3 identischen Vorgehensweise wird nach dem Entwickeln ein Resistmuster erhalten, das mit dem aus Beispiel 3 übereinstimmt. Wird allerdings erwärmt, so verliert der Resist bereits ab einer Temperatur von 70° C seine Konturen. Er weist demnach keine hinreichende Stabilität für die praktische Anwendung, insbesondere bei erhöhten Temperaturen, auf.

Beispiel 7

Es wird eine Beschichtungslösung hergestellt, enthaltend
4 Gt des Phenolharzes aus Herstellungsbeispiel 1
1 Gt des Bis-Silylenolethers (I) gemäß der deutschen Patentanmeldung P 37 30 783.5 und
0,1 Gt 2(2-Ethoxy-naphth-1-yl)-4,6-bis-trichlormethyl-s-triazin in
85 Gt Butanon.

Die Beschichtungslösung wird in an sich bekannter Weise auf einen aus Aluminium bestehenden 0,3 mm dicken Druckplattenträger aufgetragen. Der Aluminiumträger war vorher elektrochemisch aufgerauht, anodisiert und mit Polyvinylphosphonsäure hydrophiliert worden. Nach dem Trocknen der Schicht wird ein Schichtgewicht von 1,6 g/m² erhalten.

Die in dieser Weise hergestellte Offsetdruckplatte wird mit einer Kopiervorlage, die einem Halbtonkeil, Mikrolinien von einer Stärke zwischen 4 und 75 µm und Rasterpunkte von 0,5 bis 5 % Flächendeckung enthält, bedeckt. Anschließend wird mit Strahlung einer Quecksilberhochdrucklampe (5 kW) 20 s in einem Abstand von 110 cm bestrahlt. Die Entwicklung der Offsetplatte erfolgt mit einem alkalischen Entwickler der Zusammensetzung:
5,3 Gt Natriummetasilikat x 9 $H_2O$,
3,4 Gt Trinatriumorthophosphat x 12 $H_2O$,
0,3 Gt Natriumdihydrogenphosphat und
136 Gt vollentsalztes Wasser.

Nach einer Entwicklungsdauer von 60 s kann eine Druckform mit hoher Auflösung erhalten werden.

Beispiel 8 (Vergleichsbeispiel)

Es wird eine Beschichtungslösung analog zu Beispiel 7 hergestellt, mit der Ausnahme, daß anstelle des dort eingesetzten Silylenolethers ein polymerer Silylether (Verbindungen 1-8 aus der DE-A-36 01 264) verwendet wird.

Bei einer Bestrahlungsdauer von 20 s kann keine Differenzierung erzielt werden. Erst bei einer Erhöhung der Bestrahlungsdauer auf 260 s wird eine Differenzierung zwischen bestrahlten und unbestrahlten Schichtteilen beobachtet. Aber auch in diesem Fall erweist sich die Entwicklerresistenz als unzureichend. Das beobachtete fladige Ablösen läßt zudem auf eine Unverträglichkeit zwischen dem Bindemittel und dem Polysilylether schließen. Dieser Umstand erweist sich im Besonderen als auflösungsbegrenzend.

## Ansprüche

1. Positiv arbeitendes strahlungsempfindliches Gemisch, enthaltend eine Verbindung, die unter Einwirkung von aktinischer Strahlung eine Säure bildet, eine Verbindung, die durch Säure spaltbar ist, sowie ein Novolak-Bindemittel, das in Wasser unlöslich ist, in organischen Lösemitteln und Alkali löslich oder zumindest quellbar ist, und dadurch gekennzeichnet ist, daß das Novolak-Bindemittel eine Glastemperatur von mindestens 110° C aufweist.

2. Strahlungsempfindliches Gemisch nach Anspruch 1, dadurch gekennzeichnet, daß das Novolak-Bindemittel einen RMW-Wert von 10 bis 40, insbesondere 15 bis 30, aufweist.

3. Strahlungsempfindliches Gemisch nach den Ansprüchen 1 und 2, dadurch gekennzeichnet, daß das Gemisch zur Herstellung der Novolak-Bindemittel mindestens 50 Mol-% ein in meta-Position substituiertes Phenol enthält, wobei als Substituent ($C_1$-$C_3$)Alkyl, insbesondere Methyl, in Frage kommt.

4. Strahlungsempfindliches Gemisch nach einem oder mehreren der Ansprüche 1 bis 3, dadurch gekennzeichnet, daß das Gemisch zur Herstellung der Bindemittel

a) mindestens zu 60 Mol-% ein in meta-Position substituiertes Phenol enthält und bis zu 40 Mol-% ein trioder bireaktives Phenol der allgemeinen Formel I

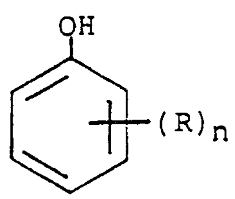 (I)

aufweist, worin
R ($C_1$-$C_4$)Alkyl, insbesondere Methyl, Ethyl und/oder t-Butyl und
n eine ganze Zahl von 1 bis 3, insbesondere 2 oder 3
bedeuten, oder

b) mindestens zu 70 Mol-% das in meta-Position substituierte Phenol enthält und bis zu 30 Mol-% ein monoreaktives Phenol der allgemeinen Formel II

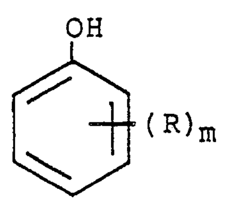 (II)

aufweist, worin
R ($C_1$-$C_4$)Alkyl, insbesondere Methyl, Ethyl und/oder t-Butyl und
m eine ganze Zahl von 2 bis 4, insbesondere 3

bedeutet.

5. Strahlungsempfindliches Gemisch nach einem oder mehreren der Ansprüche 1 bis 4, dadurch gekennzeichnet, daß als Bindemittel reine m-Kresol-Harze oder Bindemittelgemische aus m-Kresol und weiteren tri- bzw. bireaktiven Verbindungen der allgemeinen Formel I verwendet werden, in denen die Position 2 und 3 bzw. 3 und 5 oder 2,3 und 5 substituiert sind, sowie Bindemittelgemische aus m-Kresol und monoreaktive Verbindungen der allgemeinen Formel II, in denen die Position 2,3 und 6 substituiert sind.

6. Strahlungsempfindliches Gemisch nach einem oder mehreren der Ansprüche 1 bis 5, dadurch gekennzeichnet, daß das Gemisch zur Herstellung der Bindemittel 0,85 bis 0,95 Mol einer Carbonylverbindung, insbesondere Formaldehyd zu 1 Mol eingesetztem Phenol enthält.

7. Positiv arbeitendes Aufzeichnungsmaterial für die Leiterplattenherstellung und zur Herstellung von Offsetdruckplatten, im wesentlichen bestehend aus einem Träger und einer strahlungsempfindlichen Schicht, dadurch gekennzeichnet, daß die Schicht aus einem strahlungsempfindlichen Gemisch gemäß den Ansprüchen 1 bis 6 hergestellt ist.

8. Verfahren zur Herstellung eines positiv arbeitenden Aufzeichnungsmaterial nach Anspruch 7, dadurch gekennzeichnet, daß ein strahlungsempfindliches Gemisch gemäß den Ansprüchen 1 bis 6 auf einen ggf. mit einem Haftvermittler beaufschlagten Träger aufgebracht, das Material getrocknet wird, anschließend mit aktinischer Strahlung bildmäßig bestrahlt und abschließend das Bild durch Ent wickeln mit einem wäßrig-alkalischen Entwickler freigelegt wird.

9. Verfahren nach Anspruch 8, dadurch gekennzeichnet, daß die Resiststruktur nach dem Entwickeln bei erhöhter Temperatur und durch Bestrahlen mit UV-Licht nachgehärtet wird.